# EUROPEAN PATENT SPECIFICATION

(11) **EP 0 683 716 B1**
(45) Date of publication and mention of the grant of the patent: **16.07.1997**
(21) Application number: 93911536.6
(22) Date of filing: 31.03.1993
(51) Int. Cl.: B29C 35/02, B32B 31/00, B29C 65/34, B30B 7/02

(54) **PROCESS FOR THE PRODUCTION OF PLASTIC LAMINATES WITH METAL LAMINAE ESPECIALLY FOR PRINTED CIRCUITS MADE FROM ENDLESS BANDS**
Verfahren zum Herstellen von Metall-Kunstoff-Laminaten,insbesondere Leiterplatten aus endlosen Banden.
PROCEDE POUR FABRIQUER DES STRATIFIES EN PLASTIQUE AVEC DES LAMELLES METALLIQUES CONSTITUEES A PARTIR DE BANDES CONTINUES, SPECIALEMENT DESTINE AUX CIRCUITS IMPRIMES

(30) Priority: 10.02.1993 IT MI930224
(43) Date of publication of application: 29.11.1995
(73) Proprietor: CEDAL S.R.L., I-20148 Milano (IT)
(72) Inventor: CERASO, Bruno, I-20148 Milano (IT)
(74) Representative: Filippi, Remo
(86) International application number: PCT/IT93/00030
(87) International publication number: WO 94/17976

(56) References cited:
- DE-A- 3 507 568
- DE-A- 3 539 990
- DE-A- 4 001 835
- GB-A- 1 321 305
- GB-A- 2 119 710
- PATENT ABSTRACTS OF JAPAN vol. 8, no. 40 (M-278)(1477) 21 February 1984 & JP,A,58 197 017 (MASUHIRO MITSUYAMA) 16 November 1983
- PATENT ABSTRACTS OF JAPAN vol. 9, no. 46 (M-360)(1769) 27 February 1985 & JP,A,59 185 600 (HITACHI) 22 October 1984

## Description

The invention concerns processes for making plastic laminates using metal laminae.

In the normal way plastic laminates consist of several layers, stably associated generally by pressing, of plastic materials on a base of paper, fibreglass fabrics or other materials.

The plastic materials may be of phenol, melamine, epoxy, polyester, silicon, fluoride or others.

In the production of printed circuits a metal lamina,especially of copper, is made to adhere on one or both sides of the circuit during the pressing process.

A pile of substantially similar packages is formed, each of which comprises a number of sheets impregnated with plastic materials with the copper laminae placed outermost.

A sheet of metal such as stainless steel or some other is placed between each package and the pile of packages is put in a multiplate press giving heat and pressure simultaneously.

At the close of the thermic cycle, which includes a cooling stage, a compact and rigid product is obtained whose individual components are closely associated together.

Presses suitable for this kind of production are complex and give a low output because of having many plates, of having to produce heat and pressure at the same time and in well defined and precise sequences, because of having to create, by conduction, even temperatures in the various packages in the pile of which, obviously, only those at the top and bottom of the pile are in contact with the heating plates.

The presence of many heating plates not only complicates the structure of the press but also makes package loading and unloading a lengthy operation, while problems occur over short production runs because of the difficulties of amortizing costs.

In particular, the penetration of heat from the plates through the pile of packages is hindered because of the distance it must travel to reach the innermost package.

These difficulties result in high costs, for the press itself and for running it, in waste of materials, in long processing times and therefore in a more costly product.

The invention here presented greatly lessens the above drawbacks while offering considerable advantages as will be explained below.

Subject of the invention is a process for making plastic laminates, especially those for printed circuits, by the formation of piles of packages each comprising a high-insulation plate, of prepreg or another material, herinafter called "prepreg", and metal laminae,especially of copper, hereinafter called "laminae", on both surfaces of said prepreg.

Sheets of stainless steel or other material, hereinafter called "sheets" are placed between one package and another.

The pile of packages is placed in a press where pressure and heat are applied simultaneously.

According to the invention the two laminae are made from two continuous bands.

The first section of the first band is laid on the first surface of prepreg of a first package.

In its first section the second band is laid on the second face of the prepreg of the first package, and in its second section, after placing of a sheet and after said band has made a bend at 180°, on the second face of said sheet.

A second section of the first band is laid on the second face of the prepreg of the second package next to the first one, and a third section, after a second sheet has been laid, and after a bend of 180°, on the second face of said sheet.

The third section of the second band, after making a bend of 180°, is placed on the second face of the prepreg of the third package, and so on through the pile of packages keeping a layer of electrical insulation between the bands.

The first and last ends of the two bands are connected to a suitably powered generator of electric current.

Thus, when adequate pressure is applied to the pile of packages and on closing the generator's electric circuit, the various sections of the two bands,matching respectively with the two faces of the packages, will act as electric heating elements causing close association among the different layers and the formation of plastic laminates.

Layers or other equivalent means giving a high degree of electrical insulation, are placed between the sheets and continuous bands.

Preferably the bands are made of copper.

In one preferred execution the ends of the two bands appear on the same side of the pile for easier connection to the generator of electricity.

It is of an advantage if the two bands make their 180° bends alternatively on one side of the pile of packages and on the opposite side.

Pressure on the pile of packages may be determined by placing said pile in a cold press or in an autoclave.

In one execution the pile is put into a die having a plate at the top and bottom connected by supporting and guiding pins.

The pressure required for the process is obtained by placing said die in a cold press or in an autoclave.

The invention clearly possesses advantages.

There being no need for the press to provide heat and pressure simultaneously, it can be a simple one and of many kinds and of different power capacities according to the type of laminate required as long as it can produce sufficient pressure.

Heating is generated inside each package, such as can rise to a uniform temperature on all components in a short time.

Series of both large and small quantities can be made.

Heating is much quicker compared with that obtainable from present presses in which it has to penetrate some distance before reaching right inside the pile of packages.

By using a mixed form of heating, combining the traditional type of heating plates at each end of the pile of packages with this endothermic form, processing times are much shorter and productivity is consequently much higher.

Work sequences are not only faster but are also simpler reducing waste and there fore appreciably lowering costs.

Characteristics and purposes of the invention will become still clearer from the following example of execution illustrated by a diagrammatically drawn figure.

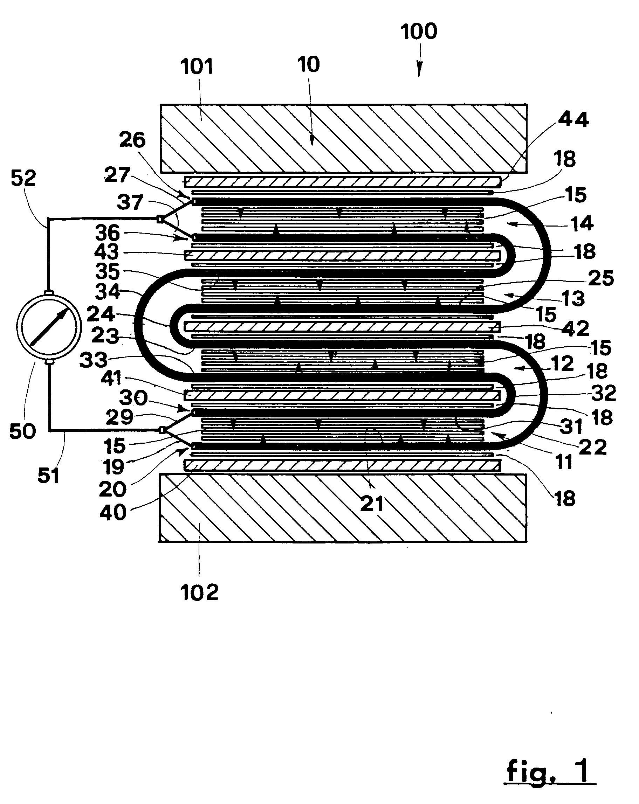

- Fig. 1: A pile of packages with metal laminae,made of bands of copper and laid serpentine-wise, in a cold press.

The pile 10,placed between the plates 101,102 of a press 100, is composed of packages 11-14 each comprising layers 15 of fibreglass fabric impregnated with epoxy resins.

Steel sheets 40-44, with interposed layers 18 for electrical insulation, are placed between one package and another.

The sheet 40, laid on the lower plate 102, has placed upon it a layer 18 of insulating material and on top of this the first section 21 of a first copper band 20. Above said section is the layer 15 of prepreg and on top of that is the first section 31 of the second copper band 30 and a layer 18 of electrical insulating material all of which form the first package 11.

The sheet 41 and the insulating layer 18 are then laid.

After the second band has made a sharp 180° turn 32, it rests on said layer with the section 33 of band.

The second layer 15 of prepreg 15 is then laid and on this, after making a bend 22 at 180° degrees lies the second section 23 of the first band 20 forming a second package 12.

After an insulating layer 18, a third sheet 42 of stainless steel is laid and another insulating layer 18.

The band 20 makes another 180° turn 24 and its third section 25 lies over the sheet 42.

After making a second 180° turn 34, the second band 30 is laid above the third layer of prepreg 15 and package 13 is formed.

Finally the first band 20 appears at the top of the package with its end 26 while the second band 30 appears with its end 36.

At the start of package formation the bands are connected to join sections 19,29 and to lead 51.

The beginning and terminating ends of the bands are connected, by means of respective join sections 19, 29 and 27, 37, and of leads 51 and 52, to the generator 50 of electric current.

On starting up the press 100 with simultaneous closure of the electric circuit, the bands 20 and 30 act as electric heating elements and heat reaches the packages 11-14 as indicated by the arrows.

The pressing process with endothermic heating is then carried out.

## Claims

1. Process for the production of plastic laminates,especially for printed circuits, by formation of piles (10) of packages (11-14) each comprising a high-insulation layer of prepreg (15), hereinafter called "prepreg" and metal laminae (20-25) especially copper laminae, hereinafter called "laminae", on each side of said prepreg, sheets of stainless steel or of other material (40-44), hereinafter called "sheets", being placed between one package and another, then by insertion in a press to receive pressure and heat,
characterized in that the two laminae are made from two continuous bands (20,30), the first section (21) of the first band (20) being laid over the first face of the prepreg (15) of a first package (11), a first section (31)of the second band (30) being laid over the second face of the prepreg (15) of the first package (11) and a second section (33), after deposition of a sheet (41) and after a 180° bend, on the second face of this latter sheet (41), a second section (23) of the first band (20) being laid on the second face of the prepreg (15) of the second package (12) and a third section (25), after deposition of a second sheet (42) and a 180° bend,on the second face of said sheet (42), the third section (35) of the second band (30), after a 180° bend, being placed on the second face of the prepreg (15) of the third package (13) and so on up to the end of the pile (10) of packages (11-14), electric insulation being maintained between the two bands (20,30), the first and last ends of the two bands (20,30) being connected to a generator (50) of electric current of suitable power so that by applying adequate pressure on the pile (10) of packages (11-14) and closing the electric circuit of the generator (50), the various sections of the two bands (20,30), matching respectively with one face and the other of the packages (11-14), act as electric heating elements, creating close association among the different layers (15,20,30) and forming plastic laminates.

2. Process as in claim 1,
characterized in that layers (18) or their equivalent, offering high electrical insulation, are placed between the sheets (40-44) and continuous bands (20,30).

3. Process as in claim 1,
characterized in that the bands (20,30) are of copper.

4. Process as in claim 1,
characterized in that the two ends of the bands (20,30) come out on the same side of the pile (10) for easier connection with the generator (50) of electric current.

5. Process as in claim 1,
characterized in that each of the two bands (20,30) are made to form 180° bends alternatively on one side of the pile (10) of packages (11-14) and on the opposite one.

6. Process as in claim 1,
characterized in that pressure on the pile (10) of packages (11-14) is obtained by placing said pile (10) inside a cold press (100).

7. Process as in claim 1,
characterized in that pressure on the pile (10) of packages (11-14) is obtained by putting said pile (10) in an autoclave.

8. Process as in claim 1,
characterized in that each pile (10) of packages is placed inside a die having an upper and lower plate connected by supporting and guiding pins, the pressure necessary for the process being obtained by placing said die in a cold press.

9. Process as in claim 1,
characterized in that each pile of packages is placed inside a die having upper and lower plates connected by supporting and guiding pins, the pressure necessary for the process being obtained by placing said die in an autoclave.

## Patentansprüche

1. Verfahren für die Herstellung von Kunststofflaminaten, und zwar insbesondere für gedruckte Schaltungen, durch die Bildung von Stapeln (10) von Paketen (11-14), die jeweils eine hochisolierte Platte aus Pre-preg (15) oder anderem Material unifassen, nachstehend als "Pre-preg" bezeichnet, sowie Metallfolien (20-25), insbesondere aus Kupfer, nachstehend als "Folien'' bezeichnet, wobei an beiden Seiten dieses Pre-preg, zwischen dem einen und dem anderen Paket, Platten (40-44) aus Edelstahl oder anderem Material angeordnet sind, die nachstehend "Platten" genannt werden, durch Einsetzen in eine Presse (100) und Aufbringen von Druck und Wärme,
dadurch gekennzeichnet, daß die beiden Folien aus zwei durchgehenden Bändern (20, 30) gewonnen werden, wobei das erste Stück (21) des ersten Bands (20) an der ersten Seite des Pre-preg (15) eines ersten Pakets (11) angeordnet ist, ein erstes Stück (31) des zweiten Bands (30) an der zweiten Seite des Pre-preg (15) des ersten Pakets (11) und ein zweites Stück (33) nach der Ablage einer Platte (41) und nach einer Biegung um 180° an der zweiten Seite dieser letzteren Platte (41) angeordnet wird, wobei ein zweites Stück (23) des ersten Bands (20) an der zweiten Seite des Pre-preg (15) des zweiten Pakets (12) und ein drittes Stück (25) nach der Ablage einer zweiten Platte (42) und einer Biegung um 180 auf der zweiten Seite dieser Platte (42) abgelegt wird und das dritte Stück (35) des zweiten Bands (30) nach einer Biegung um 180° auf der zweiten Seite des Pre-preg (15) des dritten Pakets (13) angeordnet wird, und so weiter, bis zum Ende des Stapels (10) der Pakete (11- 14), wobei eine elektrische Isolierung zwischen den beiden Bändern (20, 30) beibehalten und das erste und die beiden letzten Enden der beiden Bänder (20, 30) mit einem Stromerzeuger (50) angemessener Leistung verbunden werden, um an den Stapeln (10) von Paketen (11-14) einen entsprechenden Druck zu erzeugen, wobei die einzelnen Stücke der beiden Bänder (20, 30), die jeweils auf die eine und die andere Seite der Pakete (11-14) passen, bei Schließung des Stromkreises des Stromerzeugers (50) als elektrische Widerstände funktionieren und die enge Verbindung zwischen den einzelnen Elementen (15, 20, 30) sowie die Entstehung der Kunststofflaminate bewirken.

2. Verfahren gemäß Anspruch 1),
dadurch gekennzeichnet, daß zwischen den Platten (40-44) und den durchgehenden Bändern (20, 30) Folien (18) oder andere gleichwertige Mittel mit hoher elektrischer Isolierung angeordnet sind.

3. Verfahren gemäß Anspruch 1),
dadurch gekennzeichnet, daß die Bänder (20, 30) aus Kupfer sind.

4. Verfahren gemäß Anspruch 1),
dadurch gekennzeichnet, daß die beiden Enden der beiden Bänder (20, 30) sich an der selben Seite der Stapel (10) befinden, und zwar zwecks Vereinfachung des Anschlusses an den Stromerzeuger (50).

5. Verfahren gemäß Anspruch 1),
dadurch gekennzeichnet, daß jedes der beiden Bänder (20, 30) 180° betragende Biegungen aufweist, und zwar jeweils abwechselnd an einer Seite des Stapels (10) von Paketen (11-14) und an der gegenüberliegenden.

6. Verfahren gemäß Anspruch 1),
dadurch gekennzeichnet, daß der Druck auf den Stapel (10) von Paketen (11-14) durch Einsetzen des Stapels (10) selbst in eine kalte Presse (100) bewirkt wird.

7. Verfahren gemäß Anspruch 1),
dadurch gekennzeichnet, daß der Druck auf den Stapel (10) von Paketen (11-14) durch Einsetzen des Stapels (10) selbst in einen Druckkessel bewirkt wird.

8. Verfahren laut Anspruch 1),
dadurch gekennzeichnet, daß jeder Stapel (10) von Paketen in eine Form gesetzt wird, die eine obere und untere Platte umfaßt, die durch Halte- und Führungszapfen miteinander verbunden sind, wobei der für das Verfahren notwendige Druck durch Einsetzen dieser Form in eine kalte Presse erzielt wird.

9. Verfahren gemäß Anspruch 1),
dadurch gekennzeichnet, daß jeder Stapel (10) von Paketen (11-14) in eine Form gesetzt wird, die eine obere und eine untere Platte umfaßt, die durch Halte- und Führungszapfen miteinander verbunden sind, wobei der für das Verfahren notwendige Druck durch Einsetzen dieser Form in einen Druckkessel erzielt wird.

## Revendications

1. Procédé pour la production de laminés plastiques en particulier pour circuits imprimés, par formation de piles (10) de paquets (11-14) comprenant chacun une plaque à haute isolation, de matière préimprégnée (15) ou autre, dorénavant indiquée par le terme "prepreg" et des lames métalliques (20-25) en particulier de cuivre, dorénavant indiquées par le terme "lames", sur les deux faces de ce prepreg, des plaques (40-44) en acier inox ou d'un autre matériel, dorénavant indiquées par le terme "plaques" étant disposées entre deux paquets moyennant l'introduction dans une presse (100) et l'apport de pression et de chaleur,
caractérisé par le fait que les deux lames sont obtenues de deux rubans (20, 30) continus, le premier trait (21) du premier ruban (20) étant disposé en correspondance de la première face du prepreg (15) d'un premier paquet (11), un premier trait (31) du second ruban (30) étant disposé sur la seconde face du prepreg (15) d'un premier paquet (11) et un second trait (33) après dépôt d'une plaque (41) et avoir fait un pli à 180°, sur la seconde face de cette dernière plaque (41), un second trait (23) du premier ruban (20) étant déposé sur la seconde face du prepreg (15) du second paquet (12) et un troisième trait (25) après dépôt d'une seconde plaque (42) et avoir fait un pli à 180°, sur la seconde face de cette plaque (42), le troisième trait (35) du second ruban (30) après avoir fait un pli à 180°, étant disposé sur la seconde face du prepreg (15) du troisième paquet (13) et ainsi de suite jusqu'à la fin de la pile (10) de paquets (11-14), l'isolation électrique étant maintenue entre les deux extrémités des deux rubans (20, 30), les deux premières et les deux dernières extrémités des deux rubans (20; 30) étant connectées à un générateur (50) de courant électrique de puissance adéquate de sorte qu'en générant sur la pile (10) de paquets (11-14) une pression adéquate et en fermant le circuit électrique du générateur (50), les différents traits des deux rubans (20, 30) coïncidant respectivement avec l'une et avec l'autre face des paquets (11 - 14), se comportent comme des résistances électriques et déterminent la connexion intime entre les différents éléments (15, 20, 30) et la formation des laminés plastiques.

2. Procédé conformément à la revendication 1),
caractérisé par le fait qu'entre les plaques (40-41) et les rubans (20, 30) continus, sont disposées des feuilles (18), ou un autre moyen équivalent, à haute isolation électrique.

3. Procédé conformément à la revendication 1),
caractérisé par le fait que les rubans (20-31) sont en cuivre.

4. Procédé conformément à la revendication 1),
caractérisé par le fait que le deux extrémités des deux rubans (20, 30) sont situées sur le même flanc que la pile (10) pour faciliter la connexion au générateur (50) de courant électrique.

5. Procédé conformément à la revendication 1),
caractérisé par le fait que chacun des deux rubans (20, 30) présente des plis à 180° alternativement sur un flanc de la pile (10) de paquets (11 - 14) et sur celui opposé.

6. Procédé conformément à la revendication 1),
caractérisé par le fait que la pression sur la pile (10) de paquets (11-14) est déterminée en insérant la pile (10) à l'intérieur d'une presse (100) à froid.

7. Procédé conformément à la revendication 1),
caractérisé par le fait que la pression sur la pile (10) de paquets (11-14) est déterminée en insérant la pile (10) à l'intérieur d'un autoclave.

8. Procédé conformément à la revendication 1),
caractérisé par le fait que chaque pile (10) de paquets est placée à l'intérieur d'un moule cornprenant des plaques épaisses, une supérieure et une inférieure, assemblées par des chevilles de support et de guidage, la pression nécessaire au procédé étant déterminée en insérant ce moule dans une presse à froid.

9. Procédé conformément à la revendication 1),
caractérisé par le fait que chaque pile (10) de paquets (11-14) est placée à l'intérieur d'un moule comprenant des plaques épaisses, une supérieure et une inférieure, assemblées par des chevilles de support et de guidage, la pression nécessaire au procédé étant déterminée en insérant ce moule dans un autoclave.
